# EUROPEAN PATENT APPLICATION

(11) **EP 4 395 507 A1**
(43) Date of publication of application: **03.07.2024**
(21) Application number: 23214853.6
(22) Date of filing: 07.12.2023
(51) Int. Cl.: H10K 59/122, H10K 59/35, H10K 102/00

(54) **BANK STRUCTURE, LIGHT EMITTING DISPLAY DEVICE INCLUDING BANK STRUCTURE, AND METHOD OF MANUFACTURING THE SAME**

(30) Priority: 30.12.2022 KR 20220191064; 16.10.2023 KR 20230138031
(71) Applicant: LG Display Co., Ltd., Seoul 07336 (KR)
(72) Inventor: SON, Jung Ho, 10845 Paju-si (KR); KIM, Eung Yong, 10845 Paju-si (KR)
(74) Representative: Finlayson, Scott Henry

(57) **Abstract**

Disclosure includes a bank structure comprising a first region to neighbor a first light emitting part and to have a first height, a second region to neighbor a second light emitting part and to have the first height, a plurality of slits parallel to each other between the first region and the second region, an isolated protrusion pattern between the plurality of slits and to have a second height greater than the first height, a third region connected to the first region and to have the second height and a fourth region connected to the second region and to have the second height.

## Description

### CROSS-REFERENCE TO RELATED APPLICATION

This application claims the benefit of Korean Patent Application No. 10-2022-0191064, filed on December 30, 2022, which is hereby incorporated by reference as if fully set forth herein.

### BACKGROUND

### Technical Field

The present disclosure relates to a display device, and more particularly, to a bank structure which may prevent leakage current between adjacent subpixels due to structural change, a light emitting display device including the bank structure, and a method of manufacturing the same.

### Description of the Related Art

As society has recently entered the information age, the field of displays for visually displaying electrical information signals has rapidly developed and, in order to satisfy such development, various display devices having excellent performance, such as slimness, light weight and low power consumption, have been developed.

Light emitting display devices, which do not require separate light sources in order to achieve compactness and clear color display and include light emitting devices within a display panel, are considered as competitive applications.

A light emitting device may include an anode and a cathode opposing each other, an emissive layer provided between the anode and the cathode, and common layers which transport holes and electrons to the emissive layer.

Among these common layers, a common layer having high mobility causes leakage current between adjacent subpixels, and thus, efforts to solve this problem are being made.

Common layers are continuously provided throughout a plurality of subpixels, and a common layer having high mobility causes lateral leakage current between adjacent subpixels. In the case that the lateral leakage current is severe, an adjacent subpixel in the OFF state emits light due to a subpixel driven at a low grayscale level, and may thus cause color leakage.

### BRIEF SUMMARY

Accordingly, the present disclosure is directed to a bank structure, a light emitting display device including the bank structure, and a method of manufacturing the same that substantially obviate one or more problems due to limitations and disadvantages of the related art.

An object of the present disclosure is to provide a light emitting display device which reduces or fully eliminates lateral leakage current by providing a structural change in the location between adjacent subpixels. Accordingly, an invention is defined in the appended claims.

Additional advantages, objects, and features of the disclosure will be set forth in part in the description which follows and in part will become apparent to those having ordinary skill in the art upon examination of the following or may be learned from practice of the disclosure. The objectives and other advantages of the disclosure may be realized and attained by the structure particularly pointed out in the written description and claims hereof as well as the appended drawings.

To achieve these objects and other advantages and in accordance with the purpose of the disclosure, as embodied and broadly described herein, a bank structure includes a first region to neighbor a first light emitting part and to have a first height, a second region to neighbor a second light emitting part and to have the first height, a plurality of slits parallel to each other between the first region and the second region, an isolated protrusion pattern between the plurality of slits and to have a second height greater than the first height, a third region connected to the first region and to have the second height and a fourth region connected to the second region and to have the second height.

According to one embodiment, a bank structure positioned between a first pixel and a second pixel has a first region adjacent to the first pixel, the first region includes a first portion and a second portion, the first portion having a first height and the second portion having a second height. The bank structure also contains a second region adjacent to the second pixel, the second region having a first portion and a second portion, the first portion having the first height and the second portion having the second height. The bank structure has a third region having a space between it and the first and second regions, the third region having the second height at a central portion thereof.

A method of making the bank structure is as follows: depositing a bank layer material over a substrate; forming a mask over the bank layer material; etching the bank layer based on the mask to obtain a first region of a first height adjacent to each light emitting element and space between each bank region.

It is to be understood that both the foregoing general description and the following detailed description of the present disclosure are exemplary and explanatory and are intended to provide further explanation of the disclosure as claimed.

### BRIEF DESCRIPTION OF THE SEVERAL VIEWS OF THE DRAWINGS

The accompanying drawings, which are included to provide a further understanding of the disclosure and are incorporated in and constitute a part of this application, illustrate embodiment(s) of the disclosure and together with the description serve to explain the principle of the disclosure. In the drawings:
FIG. 1 is a block diagram schematically illustrating a light emitting display device according to the present disclosure;
FIG. 2 is a plan view illustrating region A of FIG. 1;
FIGs. 3A, 3B, 3C and 3D are a longitudinal-sectional view taken along line I-I' of FIG. 2 of various embodiments;
FIG. 4 is a longitudinal-sectional view taken along line II-II' of FIG. 2;
FIG. 5 is a longitudinal-sectional view illustrating a light emitting structure according to one embodiment of the present disclosure;
FIG. 6A is an enlarged longitudinal-sectional view of region B of FIG. 5 according to a first embodiment.
FIG. 6B is an enlarged longitudinal-sectional view of region C of FIG. 5 according to a first embodiment.
FIG. 7A is an enlarged longitudinal-sectional view of region B of FIG. 5 according to a second embodiment.
FIG. 7B is an enlarged longitudinal-sectional view of region C of FIG. 5 according to a second embodiment.
FIG. 8 is a longitudinal-sectional view illustrating a process of manufacturing the bank structure of the light emitting display device according to the present disclosure; and
FIG. 9 is a photograph of the cross-section of a bank structure manufactured by an experimental example.

### DETAILED DESCRIPTION

Reference will now be made in detail to preferred embodiments of the present disclosure, examples of which are illustrated in the accompanying drawings. Wherever possible, the same reference numbers will be used throughout the drawings to refer to the same or like parts. In the following description of the present disclosure, detailed descriptions of known functions and configurations incorporated herein will be omitted when the same may obscure the subject matter of the present disclosure. In addition, the names of elements used in the following description are selected in consideration of clarity of description of the specification, and may differ from the names of elements of actual products.

The shape, size, dimensions (e.g., length, width, height, thickness, radius, diameter, area, etc.), ratios, angles, number, and the like shown in the drawings to illustrate various embodiments of the present disclosure are merely provided for illustration, and the disclosure is not limited to the content shown in the drawings. A dimension including size and a thickness of each component illustrated in the drawing are illustrated for convenience of description, and the present disclosure is not limited to the size and the thickness of the component illustrated, but it is to be noted that the relative dimensions including the relative size, location, and thickness of the components illustrated in various drawings submitted herewith are part of the present disclosure.

Wherever possible, the same reference numbers will be used throughout the drawings to refer to the same or like parts. In the following description, detailed descriptions of technologies or configurations related to the present disclosure may be omitted so as to avoid unnecessarily obscuring the subject matter of the present disclosure. When terms such as "including," "having," and "comprising" are used throughout the specification, an additional component may be present, unless "only" is used. A component described in a singular form encompasses a plurality thereof unless particularly stated otherwise.

The components included in the embodiments of the present disclosure should be interpreted to include an error range, even if there is no additional particular description thereof.

In describing the variety of embodiments of the present disclosure, when terms describing positional relationships such as "on," "above," "under" and "next to" are used, at least one intervening element may be present between the two elements, unless "immediately" or "directly" is used.

In describing the variety of embodiments of the present disclosure, when terms related to temporal relationships, such as "after," "subsequently," "next" and "before," are used, the non-continuous case may be included, unless "immediately" or "directly" is used.

In describing the variety of embodiments of the present disclosure, terms such as "first" and "second" may be used to describe a variety of components, but these terms only aim to distinguish the same or similar components from one another. Accordingly, throughout the specification, a "first" component may be the same as a "second" component within the technical concept of the present disclosure, unless specifically mentioned otherwise.

Features of various embodiments of the present disclosure may be partially or completely coupled to or combined with each other, and may be variously inter-operated with each other and driven technically. The embodiments of the present disclosure may be carried out independently from each other, or may be carried out together in an interrelated manner.

As used herein, the term "doped" means that, in a material that accounts for most of the weight of a layer, a material (for example, N-type and P-type materials, or organic and inorganic substances) having physical properties different from the material that occupies most of the weight ratio of the layer is added in some amount. In other words, the "doped" layer refers to a layer that is used to distinguish a host material from a dopant material of a certain layer. Also, the term "undoped" refers to any case other than the "doped" case. For example, when a layer contains a single material or a mixture of materials having the same electrical properties as each other, the layer is included in the "undoped" layer. For example, when all host materials constituting a certain layer are organic or inorganic materials, if at least one of the materials constituting the layer is n-type and the other is neutral or p-type, when the n-type material is present in a selected amount usually less than 30 wt%, or when the p-type material is present in a selected amount, usually less than 30 wt%, the layer is included in the "doped" layer.

Hereinafter, a bank structure, a light emitting display device including the bank structure, and a method of manufacturing the same according to the present disclosure will be described with reference to the accompanying drawings.

Hereinafter, the light emitting display device according to the present disclosure will be described with reference to the accompanying drawings.

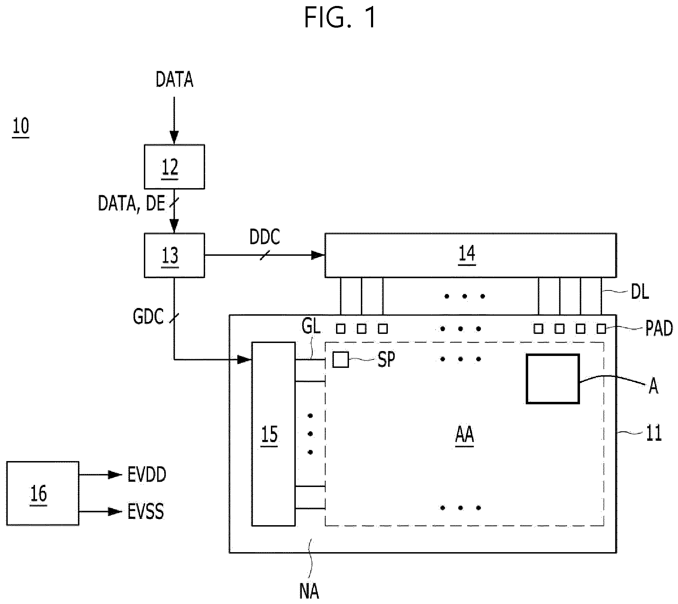

FIG. 1 is a block diagram schematically illustrating the light emitting display device according to the present disclosure.

As shown in FIG. 1, a light emitting display device 10 according to one embodiment of the present disclosure may include a display panel 11, an image processor 12, a timing controller 13, a data driver 14, a scan driver 15, and a power supply 16.

The display panel 11 may display an image in response to a data signal DATA supplied from the data driver 14, a scan signal supplied from the scan driver 15, and power supplied from the power supply 16.

The display panel 11 may include subpixels SP disposed in intersection regions between a plurality of gate lines GL and a plurality of data lines DL. The structure of the subpixels SP may be variously changed depending on the kind of the light emitting display device 10.

For example, the subpixels SP may be formed in a top emission structure, a bottom emission structure, or a dual emission structure. The teachings of the present disclosure can therefore be applied to top, bottom and dual emission structures. The subpixels SP indicate units in which a specific kind of color filter is formed, or units which respectively have a light emitting part without a color filter so as to emit light of their own colors. For example, the subpixels SP may include red subpixels, green subpixels, and blue subpixels. For another example, the subpixels SP may include red subpixels, blue subpixels, white subpixels, and green subpixels. The subpixels SP may have one or more different emission areas depending on light emitting characteristics. For example, blue subpixels and other subpixels configured to emit other colors may have different emission areas.

One or more subpixels SP may form one pixel. For example, one pixel may include red, green and blue subpixels, and the red, green, and blue subpixels may be repeatedly arranged. Otherwise, one pixel may include red, green, blue and white subpixels, and the red, green, blue and white subpixels may be repeatedly arranged, or the red, green, blue and white subpixels may be disposed in a quad type. In embodiments of the present disclosure, the color type, the arrangement type, the arrangement order, etc., of the subpixels may be configured in different forms depending on the light emitting characteristics, the lifespan of the light emitting device, and the specifications of the display device, without being limited thereto.

The display panel 11 may be divided into an active area AA in which the subpixels SP are arranged so as to display an image, and a non-active area NA provided around the active area AA. The scan driver 15 may be mounted on the non-active area NA of the display panel 11. Further, the non-active area NA may include a pad part PAD including pad electrodes PD.

The display panel 11 may include, for example, one substrate and an array formed on the substrate.

The image processor 12 may output a data enable signal DE, etc., together with the data signal DATA supplied from the outside. The image processor 12 may output at least one of a vertical synchronization signal, a horizontal synchronization signal or a clock signal, in addition to the data enable signal DE, and illustration of these signals will be omitted for convenience of description.

The timing controller 13 may receive the data signal DATA together with driving signals from the image processor 12. The driving signals may include the data enable signal DE. Further, the driving signals may include the vertical synchronization signal, the horizontal synchronization signal, and the clock signal. The timing controller 13 may output a data timing control signal DDC configured to control operation timing of the data driver 14 and a gate timing control signal GDC configured to control operation timing of the scan driver 15 based on the driving signals.

The data driver 14 may convert the data signal DATA supplied from the timing controller 13 into a gamma reference voltage by sampling and latching the data signal DATA in response to the data timing control signal DDC supplied from the timing controller 13, and may output the gamma reference voltage.

The data driver 14 may output the data signal DATA through the data lines DL. The data driver 14 may be implemented in the form of an Integrated Circuit (IC). For example, the data driver 14 may be conductively connected to the pad electrodes PD disposed in the non-active area NA of the display panel 100 through a flexible circuit film (not shown).

The scan driver 15 may output the scan signal in response to the gate timing control signal GDC supplied from the timing controller 13. The scan driver 15 may output the scan signal through the gate lines GL. The scan driver 15 may be implemented in the form of an Integrated Circuit (IC), or may be implemented as a Gate In Panel (GIP) circuit on the display panel 111.

The power supply 16 may output high voltage and low voltage to drive the display panel 11. The power supply 16 may supply the high voltage to the display panel 11 through a first power line EVDD (a driving power line or a pixel power line), and may supply the high voltage to the display panel 11 through a second power line EVSS (an auxiliary power line or a common power line).

The display panel 11 may be divided into the active area AA and the non-active area NA, and may include a plurality of subpixels SP defined by the gate lines GL and the data lines DL which intersect each other in a matrix in the active area AA.

The subpixels SP may include subpixels configured to emit at least two of red light, green light, blue light, yellow light, magenta light, or cyan light. Further, a specific kind of color filter may be formed in the plurality of subpixels SP, or the plurality of subpixels SP may emit light of their own colors without a color filter. However, the present disclosure is not limited thereto, and the color type, the arrangement type, the arrangement order, etc., of the subpixels SP may be configured in various forms depending on light emitting characteristics, the lifespan of the light emitting devices, the specifications of the display device, etc.

A phenomenon may occur in which, when one subpixel out of adjacent subpixels emits light, a neighboring subpixel emits light due to lateral leakage current. Such lateral leakage current may visually stand out to a user when viewing the screen in the case of driving at a low grayscale level.

The light emitting display device 10 according to the present disclosure provides a number of techniques and structures to increase resistance in a functional layer having high mobility by increasing the resistance in a path between adjacent subpixels (light emitting parts) through structural change in a bank structure, thereby being capable of preventing color leakage due to leakage current.

For this purpose, a bank structure, a display panel and method of making these according to the present disclosure will be described.

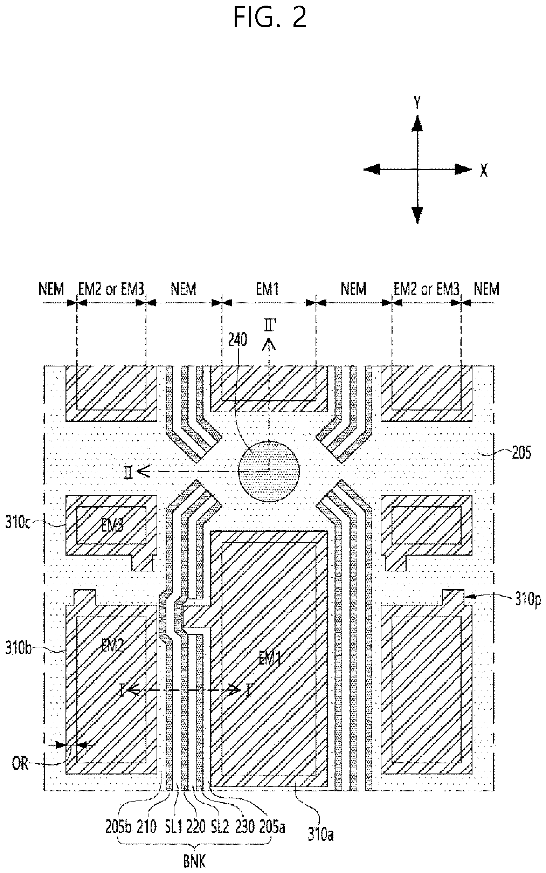

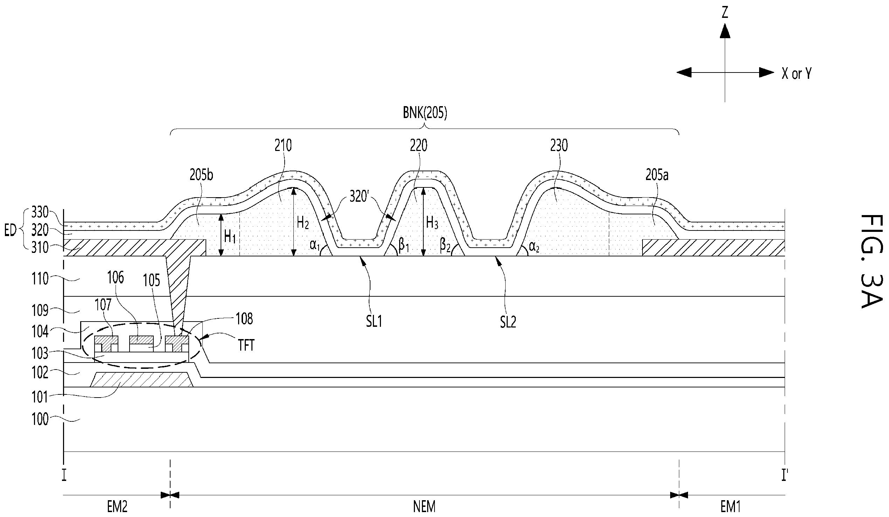

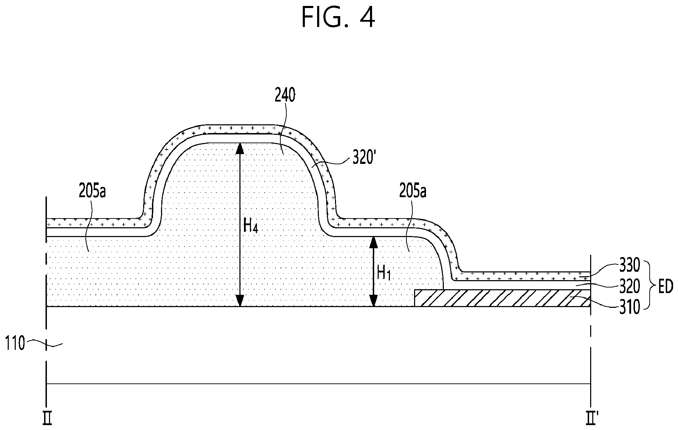

FIG. 2 is a plan view illustrating region A of FIG. 1; FIGs. 3A-3D are a longitudinal-sectional view taken along line I-I' of FIG. 2 of various embodiments; and FIG. 4 is a longitudinal-sectional view taken along line II-II' of FIG. 2.

A bank structure BNK according to one embodiment of the present disclosure is a kind of pixel defining layer configured to expose a plurality of light emitting parts EM1, EM2 and EM3. The bank structure BNK of the light emitting display device according to the present disclosure has a patterned configuration having a plurality of irregularities in non-emitting parts NEM between light emitting parts EM1, EM2 and EM3. Further, the bank structure BNK according to the present disclosure is provided to have at least three heights between the light emitting parts EM1, EM2 and EM3 through division of one mask into a plurality of sections, and differs from currently used and well-known bank structures that have a flat upper surface between light emitting parts.

Each of light emitting parts EM1, EM2, EM3, etc. are included in pixels, which includes within its definition sub-pixels, and the bank structure BNK is positioned between the pixels. Namely the bank material layer 205 is positioned between the respective pixels as shown in FIG. 2. The structure of FIG. 2 shows five complete pixels, of which the emission areas of three, EM1, EM2 and EM3 are labelled and the rest are not labelled for simplicity. It also shows parts of three other pixels above these five pixels and an isolated spacer 240 positioned in a central region of these pixels. The spacer 240 is provided at selected locations on the substrate to provide a standoff for one or more masks during the manufacturing process. As noted elsewhere herein, the display device is formed on master substrate that might be larger than 2 or 3 meters in width and length and these spacers 240 assist in providing proper placement of the masks during the formation process of the display device.

First, second and third anodes 31 0a, 310b and 310c are provided to overlap the first, second and third light emitting parts EM1, EM2 and EM3, respectively, and edge parts OR of the first to third anodes 310a, 310b, and 310c, which extend farther outwards than the first to third light emitting parts EM1, EM2 and EM3, overlap the bank structure BNK.

A light emitting device ED including a cathode 330 opposing the anodes 310a, 310b and 310c, and an intermediate layer 320 provided between the anodes 310a, 310b and 310c and the cathode 330 is provided in each of the light emitting parts EM1, EM2 and EM3.

The intermediate light emitting layer 320 comprises a stack of light emitting layers that may include a plurality of functional layers, for example, a hole injection layer, a hole transport layer, an emissive layer, and an electron transport layer. The intermediate layer 320 may include a plurality of organic films. The intermediate layer 320 may include an inorganic dopant so as to increase efficiency of the light emitting devices ED. When the layers included in the intermediate layer 320 are continuously formed throughout the plurality of light emitting parts EM1, EM2 and EM3 without disconnection, these layers may be referred as common layers.

Referring to FIGs. 2, 3A-3D and 4, the bank structure BNK between the first light emitting part EM1 and the first light emitting part EM2 will be described in detail.

The bank structure BNK may include a first area or portion 205a configured to surround or neighbor the first light emitting part EM1, which emits light of a first color, and a second area or portion 205b configured to surround or neighbor the second light emitting part EM2, which emits light of a second color. Each of the first area 205a and the second area 205b may have the first height H1. The bank structure BNK may further include a plurality of spaces (also called slits) SL1 and SL2 located parallel to each other between the first area 205a and the second area 205b, an isolated protrusion pattern 220 located between the plurality of spaces SL1 and SL2 and configured to have a second height H3 greater than the first height H1. The height H3 can be greater than or equal to the height H2. The bank may include a third area or portion 230 connected to the first area 205a and a fourth area or portion 210 connected to the second area 205b. Each of the third and fourth portions may have the second height H2. The third region is spaced away from the first and second regions. Also, the third area is adjacent to one space SL2 among the plurality of slits, and the fourth area is adjacent to another space SL1 different from the space SL2.

The first light emitting part EM1 and the second light emitting part EM2 are along or in a first direction (in the Y-axis direction of FIG. 2), and the plurality of slits SL1 and SL2 may be provided along or in the Y-axis direction. These parts EM1 and EM2 can be parallel to the slits SL1 and SL2, but they can have other shapes as well. It is recognized that many light emitting areas are not rectangular in shape and might have many other shapes, whether octogon, or the light and the periphery of the light emitting parts and the spaces can track each other, but not be considered parallel since they might contain many angles and changes in direction.

From the first light emitting part EM1 to the isolated protrusion pattern 220 in the X-axis direction of FIG. 2, the first area 205a, the third area 230, the space between the various bank areas, is interchangeable referred to herein as slits SL1 and SL2 and the isolated protrusion pattern 220 are sequentially provided. Similarly, from the second light emitting part EM2 to the isolated protrusion pattern 220 in the X-axis direction, the second area 205b, the fourth area 210, the space SL1, namely slit SL1, and the isolated protrusion pattern 220 are sequentially positioned.

That is, the first area 205a, the third area 230, the slit SL2, the isolated protrusion pattern 220, the slit SL1, the fourth area 210 and the second area 205b having height differences are sequentially provided in the X-axis direction between the first light emitting part EM1 and the second light emitting part EM2. Such a bank structure BNK has a plurality of irregularities between the neighboring first and second light emitting parts EM1 and EM2, and may thus increase resistance on a path, through which the intermediate layer 320 passes, and reduce or prevent lateral leakage current in the intermediate layer 320. Therefore, low grayscale color leakage caused by the lateral leakage current in the common layers may be minimized. Therefore, although mobility of the common layers of the light emitting device ED is high, current flows along the long path of the bank structure BNK between the first and second light emitting parts EM1 and EM2 and encounters high resistance, and thereby, the effect of the lateral leakage current between the first light emitting part EM1 and the second light emitting part EM2 may be removed or reduced.

Viewing FIGs. 3A-3D, the regions EM1 and EM2 are parts of two different pixels and the bank structure BNK is positioned between these pixels.

Further, internal angles α₂, β₂, β₁ and α₁ formed between inclined side surfaces of the third area 230, the isolated protrusion pattern 220 and the fourth area 210 adjoining the slits SL2 and SL1, and the surface of a planarization film 110 are high angles equal to or greater than about 55°. The planarization film 110 may be used as a base layer for the forming surface of the bank structure. In some cases, a substrate or another insulating layer may be used as a forming surface on which the bank structure is positioned. More preferably, the internal angles α₂, β₂, β₁ and α₁ formed between the inclined side surfaces of the third area 230, the isolated protrusion pattern 220 and the fourth area 210 adjoining the slits SL2 and SL1, and the surface of the planarization film 110 are in the range of about 55° to 75°.

More preferably, the internal angles β₂ and β₁ of the inclined side surfaces of the isolated protrusion pattern 220 located between both slits SL1 and SL2 to be isolated are in the range of about 65° to 75°, because stability in maintenance of the height of the isolated protrusion pattern 220 is increased when the internal angles β₂ and β₁ of the inclined side surfaces of the isolated protrusion pattern 220 are in the range of about 65° to 75°. Having internal angles β₂ and β₁ in the range of 70° to 80° is also acceptable in some embodiments, thus a range of 55° to 80° can be considered acceptable for these angles. A preferred value for internal angles β₂ and β₁ is 70° ± 5°, which includes range of manufacturing tolerance. This angle is preferably obtained using an etch process and/or an ashing process of the bank structure BNK.

In the bank structure BNK according to the present disclosure, the respective layers forming the intermediate layer 320 having straightness are stacked thinly in the third area 230, the isolated protrusion pattern 220 and the spacer 240, also referred to as a fifth area or portion 240, so that some layers of the intermediate layer 320 are disconnected or formed thinly, and resistance between the first and second light emitting parts EM1 and EM2 adjoining the corresponding layers is increased, thereby being capable of preventing or minimizing lateral leakage current. Due to a combination of the steep angles β₁ and β₂ and the height of the isolated protrusion pattern 220, the stack of light emitting layers 320 will be thinner in on sidewalls of the isolated protrusion pattern 220 than in the pixel emitting regions EM1, EM2, etc. The stack of light emitting layers 320' does not emit light on these sidewalls of the isolated protrusion pattern 220 since an anode 310 is not provided at that location.

The current travelling in the stack of light emitting layers 320 between pixels will be greatly reduced for at least two independent reasons. A first reason is that the path is longer because of the high and low regions provide a more serpentine and thus longer travel path, thus greatly increasing the overall resistance of that path between the pixels. As H2 and H3 become higher the length of the travel path is increased. The increase in length is double any increase of height in each since the stack of light emitting layers 320 must travel both up and down these structures. A second reason is that the resistivity of the stack of light emitting layers 320' becomes greater when it is thinner. Since the stack of light emitting layers 320' will be thinner on the sidewalls of the isolated protrusion pattern 220 and also on sidewalls of the third area 230 and the fourth area 210 than it is over the light emitting parts EM1, EM2, etc. the resistivity of the stack of light emitting layers 320' is increased, thus increasing the overall resistance of lateral current between adjacent pixels.

The display panel 11 of FIG. 1 and the structure of FIG. 2 are portions of a master substrate that was used during the manufacturing process to conveniently form a plurality of display devices 11 at the same time in the same process steps. The master substrate can be diced or cut into individual display devices 11 that are on individual substrates after they are formed on the master substrate. In one embodiment, the master substrate is approximately 2.5 meters by 3 meters in area (approximately 8 feet by 10 feet) or it could be larger, 3.2 meters by 5 meters or 7 meters. In various embodiments, the master substrate might have in the range of 4 to 30 individual display devices 11 thereon, depending on the particular display devices being manufactured. For example, if master substrate is being used to make large screen TVs, for the display panel 11, it might be cut into four final substrates that each become a display device that are each about 1.2 meters by 1.5 meters. But, if the display device is being used to make laptop computer displays, then the master substrate might be cut into 12 or 16 final display panels 11, each being in the range of .6 meters by .75 meters.

The master substrate is large compared to the features being formed thereon. In one embodiment, the master substrate is larger than 2 meters across yet the features being formed thereon are in the range of microns in size. In some display devices, a subpixel might be in the range of 50 square microns while in others it might be 100 sq. microns or larger, while in yet others it might be under 10 microns. Various features in each sub pixel are often in the range of a few to a dozen square microns in area and less than a micron in height. A number of manufacturing techniques are used to because features of few microns in area are being formed on a substrate in the range of 8-12 sq meters. Accordingly, a wet etch is preferred for forming the various features of the bank BNK to achieve the desired angles.

As shown in FIG. 3A, a part of the surface of the isolated protrusion pattern 220 of the bank structure BNK may be flat on the top and the isolated protrusion pattern 220 may have a trapezoidal cross-section or a triangular cross-section having a round top apex, but the bank structure BNK according to the present disclosure is not limited thereto.

Further, although the above-described embodiment illustrates the bank structure BNK between the first and second light emitting parts EM1 and EM2, the bank structure BNK between the first light emitting part EM1 and the third light emitting part EM3 has a similar configuration.

As shown in FIG. 2, in the light emitting display device according to one embodiment, the second light emitting parts EM2 and the third light emitting parts EM3 are alternately disposed in the same column, and the first and third light emitting parts EM2 and EM3, which vertically neighbor each other, neighbor both sides of one first light emitting part EM1.

The second area 205b, the fourth area 210, the isolated protrusion pattern 220 may be provided along a long side of the first light emitting part EM1 (in the Y-axis direction), and may have ends located farther outwards than ends of the long side of the first light emitting part EM1.

The width of the lower surface of the isolated protrusion pattern 220 may be equal to or less than the width of the slits SL1 and SL2. Because the width of the slits SL1 and SL2 may be restricted so as to form the sufficient height of the isolated protrusion pattern 220.

The second light emitting part EM2 and the third light emitting pattern EM3 may be disposed in the length direction of the slits SL1 and SL2.

A first internal angles α₁ and α₂ of the third area and the fourth area with respect to the forming surface may be smaller than a second internal angle β₁ and β₂ of the isolated protrusion pattern with respect to a forming surface. In other words, second internal angles β₁ and β₂ formed between the isolated protrusion pattern 220 and the surface of the planarization film 110 located in the non-emitting part NEM may be greater than first internal angles α₁ and α₂ formed between the fourth and third areas 210 and 230 and the surface of the planarization film 110 located in the non-emitting part NEM. The first internal angles α₁ and α₂ 55° to 65°. Having internal angles α₁ and α₂ that are within a larger range, for example, of 70° to 75° is also acceptable in some embodiments, thus a range of 50° to 75° can be considered acceptable for these angles. The reason for this is to decrease the width of the isolated protrusion pattern 220 so as to increase the height of the isolated protrusion pattern 220, and to increase the width of the third area 230 and the fourth area 210 so as to form the stabilized height of the third area 230 and the fourth area 210 around the slits SL2 and SL1. Generally, the angles α₁ and α₂ will be somewhat smaller than the angles β₁ and β₂, but this is not required and they could be equal.

Further, as shown in FIGs. 3A-3D, the light emitting display device according to the present disclosure includes a thin film transistor TFT between a substrate 100 and the light emitting device ED for each of the pixels that have the light emitting regions EM1, EM2, EM3, etc. For simplicity in the figures, the TFT as well as any capacitors, switching transistors and other components and connections used to provide light emission for each other respective pixels are not shown, but these are present in each pixel. The bank BNK is therefore positioned between the respective pixels in the NEM area.

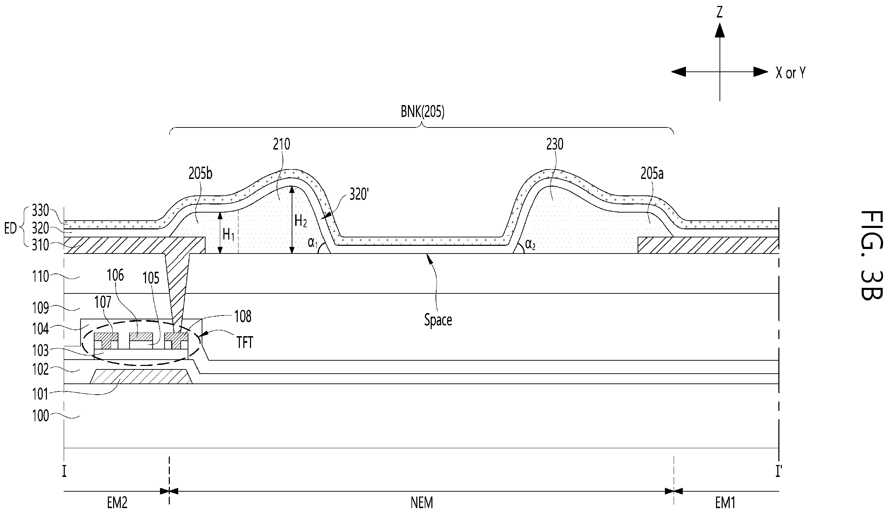

Referring now to FIG. 3B, the bank between the pixels includes two portions each having a first region 205, labelled 205a and 205b respectively and a second region labelled 210 and 230. There is a space, which is labelled Space between these two bank portions. In the Space, the protective layer 110 is exposed and the stack 320 is directly on the layer 110. This protective layer 110 extends between the pixels. In the Space region the thickness of the stack 320 will be approximately equal to the thickness of the stack 320 in the pixel light emitting regions EM1, EM2. The overall resistance is increased by the thinness of the stack 320 on the sidewalls 210 and 230. In the embodiment of 3B in which the protrusion 220 is not present, the height H2 can be increased to be equal to or greater than H4. Further the angles α₁ and α₂ can greater to be equal to or greater than those of the angles β₁ and β₂ in the embodiment of Fig. 3A. The one or more layers in the light emitting stack 320 might have very poor step coverage and thus depending on the step coverage of the stack 320 on the height H2, it might be sufficiently thin that there is little to no conduction; in some embodiments, it might be sufficiently thin as to not be deposited at all, thus breaking fully the current path between the pixels on the sidewalls of regions 210 and 230 during. In such instances, the protrusion 220 is not needed and use of the Space is sufficient to ensure electrical isolation between the pixels.

Comparing the height H2 of Fig. 3B to the spacer 240 of FIG. 4, it is to be noted that H4 ≥ H2 > H1. Further, the spacer 240 can be formed simultaneously with the bank portions of 3B having the respective heights of H1, H2 and H3, or may be formed independently.

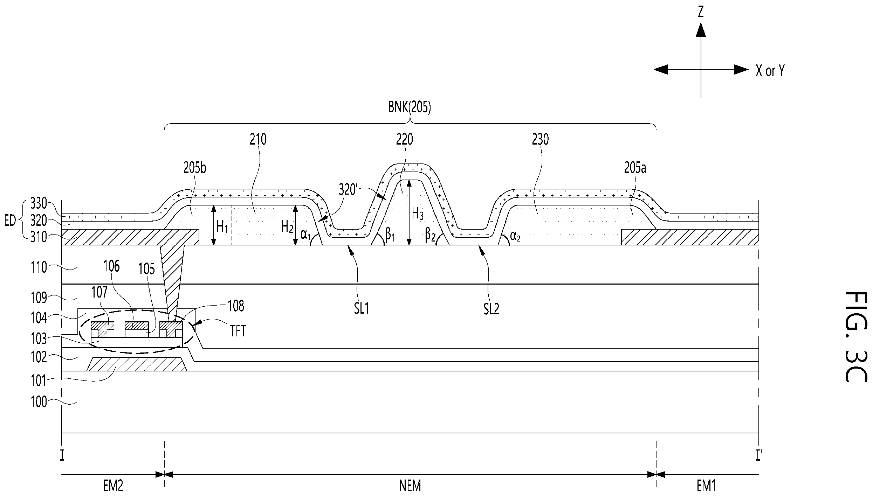

Referring to FIG. 3C, the bank between the pixels includes two portions each having a first region 205, labelled 205a and 205b respectively and a second region labelled 210 and 230 that are both the same height. Namely, the two bank portions of Fig. 3C are generally flat on top. There is protrusion 220 between them with a first space SL1 a second space SL2 separating each of them. In this embodiment, the protrusion has a height H3 for which H3 > (H1 = H2). If desired, the height of H3 can be increased to be equal to or greater than H4 to provide an increased path length for the stack 320 and also the protrusion 220 can be quite narrow in width so that the sidewalls are have a steep incline and the stack 320, having a poor step coverage, is very thin or not present at all.

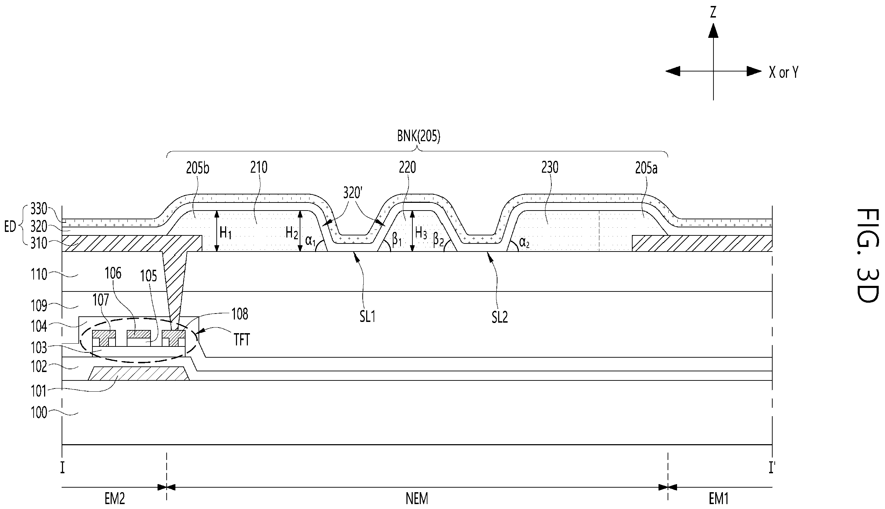

Referring to the embodiment of FIG. 3D, it is similar to the embodiment of FIG. 3C, except that the height H3 equals H2 and H1; namely, H3 = H1 = H2. The bank between the pixels includes two portions each having a first height and a flat top and the protrusion between them having a same height H3 is separated from these two bank portions by spaces SL1 and SL2.

It is too be noted that in Figures 3A-3D, 4, 5 6 and 7 that the variations in thickness of the light emitting stack 320, 320' and 320A' are not shown to scale with the changes in thickness or that actual thickness that will be present in the physical semiconductor structure after manufacture. Each deposition process will have different step coverage for the light emitting stack 320 that will depend on various factors, among the factors are the various layers and the type of materials in the various layers that make of stack 320, the actual and also relative heights of H1, H2, H3 and H4, the various angles α₁, α₂, β₁ and β₂, the deposition conditions, such as the size of the master substrate, the location of the display panel on the master substrate as compared to the source nozzles of the deposition material, the temperature during deposition and many other factors. Thus, an attempt is not made to illustrate in each figure the relative thickness and changes of thickness of the stack 320 at each location, it is sufficient to state that the stack 320 will be more thin in various place on the bank portions BNK than on in the light emitting pixel regions EM1, EM2, etc. and the exact different in thickness will be based on a number of factors that will vary for each deposition process, as is well known and within the skill of those who work in this technology area.

The thin film transistor TFT includes a semiconductor layer 103, a gate electrode 106 overlapping the semiconductor layer 103 with a gate insulating film 105 interposed therebetween, and a source electrode 107 and a drain electrode 108 spaced apart from the gate electrode 106 and connected to both ends of the semiconductor layer 103.

The semiconductor layer 103 may include at least one of an oxide semiconductor, crystalline silicon, or amorphous silicon.

Further, the semiconductor layer 103 may further include a light shielding layer 101 so as to prevent light from being transmitted from under the substrate 100.

A buffer film 102 may be further provided between the light shielding layer 101 and the thin film transistor TFT. The thin film transistor TFT may be protected by an inorganic passivation film 104 and a passivation film 109 which are sequentially provided.

The planarization film 110 may be provided on the organic passivation film 109. The planarization film 110 is a further encapsulation layer, protective layer or passivation layer for the transistors of the pixels that is overlying 109.

The buffer film 102 and the inorganic passivation film 104 may be formed of an inorganic insulating material. For example, the inorganic insulating material may be an oxide film, a nitride film, or an oxynitride film.

The organic passivation film 109 and the planarization film 110 may be formed of an organic matter, which is at least one of photoacryl, polyimide, benzocyclobutene resins, or acrylate-based resins.

The bank structure BNK and a spacer 240 may be formed of the same organic material, *i.e.,* a photosensitive organic material which may be patterned directly by an optical exposure process. The photosensitive organic material may include photoacryl or an acrylate-based resin, or may include an epoxy resin.

The intermediate layer 320 formed by deposition may come into direct contact with the upper surface of the planarization film 110 in the slits SL1 and SL2 of the bank structure BNK.

The first light emitting part EM1 is a light emitting part configured to emit blue light and, for example, has a light emitting device including an emissive layer having an emission peak at 420 nm to 490 nm.

The second light emitting part EM2 is a light emitting part configured to emit green light and, for example, has a light emitting device including an emissive layer having an emission peak at 510 nm to 590 nm.

The third light emitting part EM3 is a light emitting part configured to emit red light and, for example, has a light emitting device including an emissive layer having an emission peak at 600 nm to 650 nm.

The first area 205a, the third area 230, the slit SL2, the isolated protrusion pattern 220, the slit SL1, the fourth area 210, and the second area 205b are continuously formed in the Y-axis direction, respectively, between the first light emitting part EM1 and the third light emitting part EM3, and thus, a lateral leakage current prevention effect is exhibited by the plurality of irregularities, in a similar manner as the lateral leakage current prevention effect between the first light emitting part EM1 and the second light emitting part EM2.

In order to increase the lateral leakage current prevention effect between the first light emitting part EM1 and the third light emitting part EM3, the ends of the first area 205a, the third area 230, the slit SL2, the isolated protrusion pattern 220, the slit SL1, the fourth area 210 and the second area 205b may be provided over one end of one side of the third light emitting part EM3 neighboring the first light emitting part EM1.

The edges of the first area 205a, the third area 230, the slit SL2, the isolated protrusion pattern 220, the slit SL1, the fourth area 210 and the second area 205b may be spaced apart from the spacer 240 provided on the first area 205a surrounding the first light emitting part EM1 by a designated distance so as not to interfere with the spacer 240.

The first area 205a, the third area 230, the slit SL2, the isolated protrusion pattern 220, the slit SL1, the fourth area 210 and the second area 205b may have bent portions at the corner of the first light emitting part EM1, and thereby, the first areas 205a outside the first light emitting part EM1 are formed in a shape partially surrounding the corners of the first light emitting part EM1.

The bank structures BNK formed in a bank 205 and the spacers 240 may be acquired by patterning a material for the bank 205 using one mask.

The spacer 240 is formed together with formation of the bank 205 and has a third height H4, and the third height H4 may be greater than the second height H2 of the third and fourth areas 230 and 210. This is because, when the spacer 240 is formed, a light shielding part of the mask corresponding to the spacer 240 is formed to have a greater area than a light shielding part of the mask corresponding to the isolated protrusion pattern 220, and thus, reduction in the thickness of a photosensitive material due to loss of the material caused by interference in a portion of the material adjacent to the light shielding part may be prevented. In some embodiments, the spacer 240 may also have the height H2, the same as the portion 210 and 230 of the BNK 205. Thus, in one embodiment, H4 ≥ (H2, H3) > H1. The spacer 240 of the height H4 may be formed simultaneously with 205, 210 and 220, each of a height H1, H2, and H3) or may be formed independently of H1, H2, and H3.

The bank structure BNK increases the path, through which the intermediate layer 320 passes, between the adjacent subpixels (*i.e.*, from the first light emitting part EM1 to the second light emitting part EM2 or from the first light emitting part EM1 to the third light emitting part EM3), and thus effectively reduce lateral leakage current, and therefore, it is more effective to provide the bank structure BNK between light emitting parts configured to emit light of different colors.

However, the bank structure BNK according to the present disclosure is not limited to a position between light emitting parts configured to emit light of different colors. The bank structure BNK may be provided in the non-emitting part NEM between light emitting parts configured to emit light of the same color.

As shown in FIG. 2, each of the first to third anodes 310a, 310b and 310c has a protrusion 310p at one side thereof. The protrusion 310p of each of the first to third anodes 310a, 310b and 310c may be used as a connection part to any one electrode of the thin film transistor. However, the illustration of FIG. 2 is only one example, and the first to third anodes 310a, 310b and 310c do not necessarily have the protrusion 310p. The first to third anodes 310a, 310b and 310c may be provided in a polygonal shape without a protrusion. In this case, the thin film transistor may be connected to at least one point of each of the first to third anodes 310a, 310b and 310c having the polygonal shape.

When the first anode 310a has the protrusion 310p at the outer part thereof overlapping the first light emitting part EM1, the bank structure BNK bypasses the exposed first anode protrusion 310p, and thus, the silt SL2 may be omitted from a bypass region and the bypass region may be covered with the first area 205a of the bank 205.

The bank structure BNK is formed of the same organic material, and is simultaneously formed through one optical exposure process using a multi-tone mask. That is, the first to fourth regions and respective portions or areas 205a, 205b, 230 and 210 and the isolated protrusion pattern 220 and spacer 240 may include the same organic material and thus have the same properties. The internal angles between the edges of the isolated protrusion pattern 220 and the surface of the planarization film 110 exposed by the slits SL1 and SL2 become 55° or more due to interference at the interface between the light shielding part and the transmitting part of the mask.

In the example provided in Figs. 3A-3D herein, the display panel 11 is a bottom emission structure, however the same principles can be used to construct a top emission structure with the same benefits and technical results. Indeed, a corresponding top emission structure that is very similar, or in some instances virtually identical to Figs. 2 and 3A-3D, can be made, except that the physical location of the light emitting device ED and the bank structure BNK are switched places, with the bank structure BNK on above the top and the light emitting device ED positioned between the TFT and the bank structure.

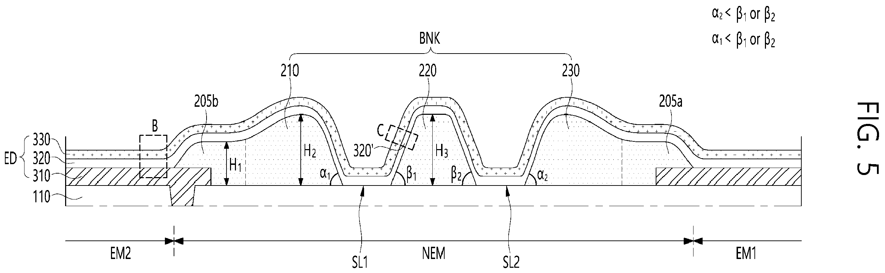

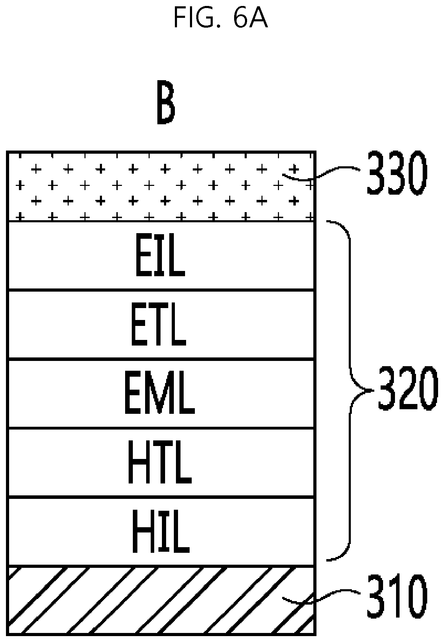

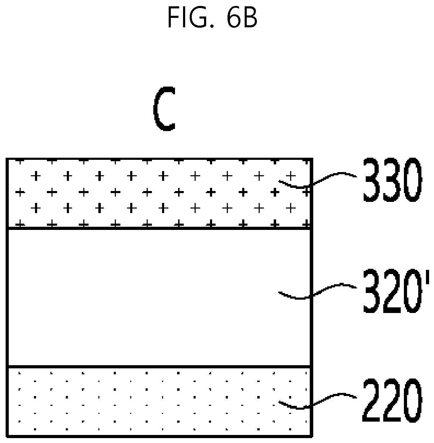

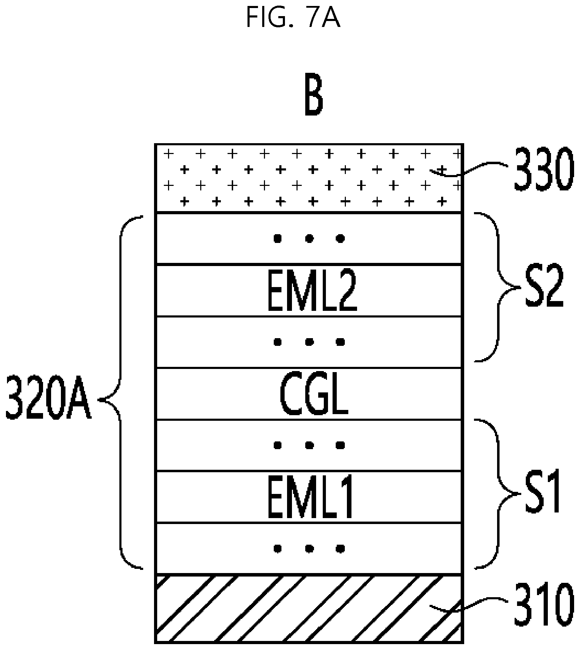

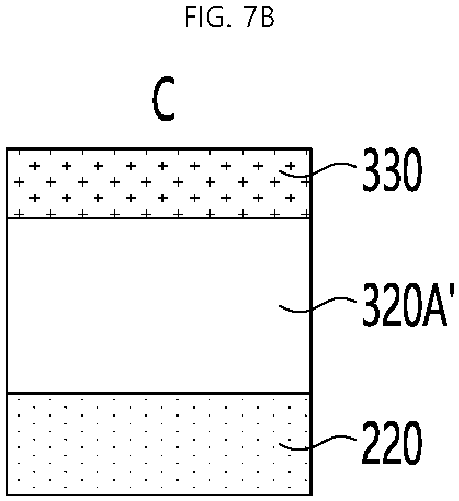

FIG. 5 is a longitudinal-sectional view illustrating a light emitting structure with the bank structure according to one embodiment of the present disclosure. FIGs. 6 and 7 are enlarged longitudinal-sectional views of region B and region C of FIG. 5, respectively, according to embodiments.

As shown in FIG. 5, a light emitting structure or a light emitting device ED of the present disclosure may comprise an anode 310, an intermediate layer 320 including at least one emissive layer and at least one common layer, and a cathode 330. The upper surface of the isolated protrusion pattern 220 of the bank structure BNK according to one embodiment of the present disclosure might have a small top region that is flat and it could have a generally rounded shape. The shape of the isolated protrusion pattern 220 may be controlled by adjusting the width of the corresponding light shielding part of the mask used to form the bank structure BNK. The height of the isolated protrusion pattern 220 may be selected based on the width of the light shielding part and can be varied by changing the width of the light shielding part, and the height of the isolated protrusion pattern 220 may be greater than the height of the third area 230 and the fourth area 210 when the width of the light shielding part is large, and may be equal to or smaller than the height of the third area 230 and the fourth area 210 when the width of the light shielding part is small. Thus the height of 220 can be H4, H3, H2, H1 or a height between them.

As shown in FIG. 6A, the light emitting device ED, as one example, may include an anode 310 and a cathode 330 opposing each other, and a hole injection layer HIL, a hole transport layer HTL, an emissive layer EML, an electron transport layer ETL and an electron injection layer EIL provided between the anode 310 and the cathode 330. These layers HIL, HTL, EML, ETL and EII, between the anode 310 and the cathode 330 serves as the intermediate layer 320 including a kind of organic layer, inorganic layer or hybrid layer. All or some of the layers HIL, HTL, EML, ETL and EIL included in the intermediate layer 320 may be common layers formed using an open mask not a fine metal mask.

As shown in FIG. 6B, The thickness of the intermediate layer 320' provided on the inclined side surface of the isolated protrusion pattern 220 is smaller than the thickness of the intermediate layer 320 on the anode 310 or the slit SL1 because step coverage of a deposited in light emitting layer 320 with respect to a high angle of inclination is poor. Namely, one or more of the layers in the light emitting 320 is generally non-conformal when being deposited and has poor step coverage during a blanket deposition. Since the sub layers in the emitting layer 320 are deposited over the entire display panel, in those locations where there is a steep incline or step, there will be poor step coverage. Thus the stack 320 will be thinner on the side walls of the protrusion 220 and also on the sidewalls of regions 210 and 230. In prior designs, this might be considered a problem or disadvantage in some display panel structures, however, the present disclosure creates a structure to make it a benefit. The present disclosure uses this feature to create a technical benefit to use it to reduce the leakage current at those locations.

Therefore, in the bank structure BNK according to the present disclosure, the length of the plurality of irregularities among the first to fourth areas 205a, 230, SL2, 220, SL1, 210 and 205b between the first and second light emitting parts EM1 and EM2 is physically increased, the thickness of the intermediate layer 320' on the side surfaces of the isolated protrusion pattern, the third area 230 and the spacer, namely the fourth area 240 is reduced, and thereby, an effect of increasing resistance is greatly increased, in some instances it is doubled or more than doubled. Therefore, the bank structure BNK according to the present disclosure is remarkably effective in preventing lateral leakage current, thus being effective in preventing color leakage at a low grayscale level.

As shown in FIG. 7A, the light emitting device ED, as one example, may include an anode 310 and a cathode 330 opposing each other, and a plurality of stacks S1, S2, ... and a charge generation layer CGL provided between the anode 310 and the cathode 330. Further, each stack includes a hole injection layer HIL, an emissive layer EMI, an electron transport layer ETL, etc. An intermediate layer 320A provided between the anode 310 and the cathode 330 may include a plurality of stacks S1, S2, ... , and each stack may include at least one common layer. The charge generation layer CGL provided between the stacks S1, S2, ... is also a common layer.

In the light emitting display device including the bank structure BNK according to the present disclosure, the thickness of the intermediate layer 320A' provided on the inclined side surface of the isolated protrusion pattern 220 is smaller than the thickness of the intermediate layer 320A on the anode 310 or the slit SL1 because step coverage of the deposited material with respect to a high angle of inclination is poor.

Therefore, in the bank structure BNK according to the present disclosure, the length of the plurality of irregularities among the first to fourth areas 205a, 230, SL2, 220, SL1, 210 and 205b between the first and second light emitting parts EM1 and EM2 is physically increased, the thickness of the intermediate layer 320A' on the side surfaces of the isolated protrusion pattern, the third area 230 and the spacer, namely the fourth area 240 is reduced, and thereby, the effect of increasing resistance is greater, in some instances, more than doubled. Therefore, the bank structure BNK according to the present disclosure is remarkably effective in reducing or fully preventing lateral leakage current, thus being effective in preventing color leakage, even at a low grayscale level.

Hereinafter, a method of manufacturing the light emitting display device according to the present disclosure will be described.

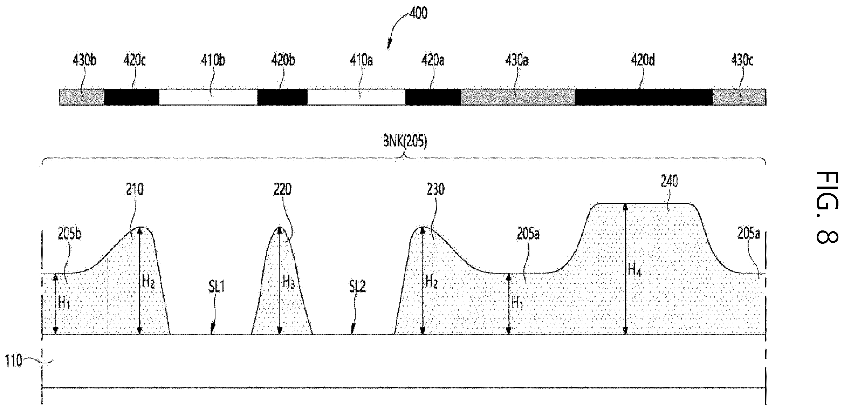

FIG. 8 is a longitudinal-sectional view illustrating a process of manufacturing the bank structure of the light emitting display device according to the present disclosure.

First, as shown in FIGs. 2 and 3A-3D, the substrate 100 including the planarization film 110 having the various transistors to drive the display panel, first light emitting parts EM1 and the second light emitting parts EM2 provided thereon is prepared.

Thereafter, a photosensitive material is applied to the planarization film 110. As noted elsewhere in, the photosensitive material can be any of a number of acceptable photoresists and can be embodied either as a part of layer 205 or overlayed on bank layer 205, which was previously deposited.

A mask 400 including a first semi-transmitting part 430a and a second semi-transmitting part 430b corresponding to the edges of the first and second light emitting parts EM1 and EM2, a plurality of, *i.e.*, three or more, light shielding parts 420a, 420b and 420c located between the first and second semi-transmitting parts 430a and 430b to be spaced apart from each other, and light transmitting parts 410a and 420b located between the plurality of light shielding parts 420a, 420b and 420c is placed on the photosensitive material.

Thereafter, the bank structure BNK including the isolated protrusion pattern 220 corresponding to the light shielding part 420b between the light transmitting parts 410a and 410b, the slits SL1 and SL2 corresponding to the light transmitting parts 410a and 410b, and areas having dual heights corresponding to the first and second semi-transmitting parts 430a and 430b is formed by exposing the photosensitive material to light through the first and second semi-transmitting parts 430a and 430b and the light transmitting parts 410a and 410b.

The mask 400 further includes an additional light shielding part 420d, and the spacer 240 corresponding to the additional light shielding part 420d is also formed during the process of forming the bank structure BNK. The first semi-transmitting part 430a and a third semi-transmitting part 430c are located around the additional light shielding part 420d, and thereby, the photoresist material in an area for the spacer 240 may maintain an initial thickness H4 compared to the isolated protrusion pattern 220 having the thickness H3 slightly reduced from the initial thickness H4 due to diffraction and interference effects at the interfaces between the edges of the second light shielding part 420b and the first and second light transmitting parts 410a and 410b, and thus, the spacer 240 having a greater thickness than the bank structure BNK remaining on the planarization film 110 may be formed. FIG. 8 illustrates that the bank structure BNK is formed using a positive-type photosensitive material, but, when the bank structure is formed using a negative-type photosensitive material, the light shielding parts 420a, 420b,, 420c and 420d may be formed as openings, and the light transmitting parts 410a and 410b may be formed as light shields, *i.e.,* in the opposite manner.

The photosensitive material that forms the mask can be the bank material layer 205 itself which is imaged and etched directly, or alternately, the bank material 205 can be deposited as a blanket layer and then the photosensitive material placed on top of it, after the photosensitive layer is patterned and the layer 205 therefore patterned and etched, as described herein, resulting in the structure of FIGs. 3A-3D, 5 and 9. The additional techniques beyond those described herein that are practiced to perform such pattern and etching are known in the art and need not be described in more detail

The slits SL1 and SL2, which may be called spaces or trench structures in the bank structure BNK may be formed through a dry etching process after patterning using the photosensitive material. However, when the size of the substrate 100 is increased, the process distribution of the dry etching process is increased to 10% or more, the internal angles α₂, β₂, β₁ and α₁ formed between the inclined side surfaces of the third area 230, the isolated protrusion pattern 220 and the fourth area 210 adjoining the slits SL2 and SL1, and the surface of the planarization film 110 or internal angles formed between the bottoms and the inclined surfaces of the trench structures in the bank structure BNK are not uniform in the substrate 1000 and thus leakage current deviation by area may occur. Therefore, when photolithography is performed as shown in FIG. 8, the angles of the inclined surfaces of the bank structure BNK may be uniformized in the substrate 100, and thus, leakage current may be uniformly prevented throughout the substrate 100.

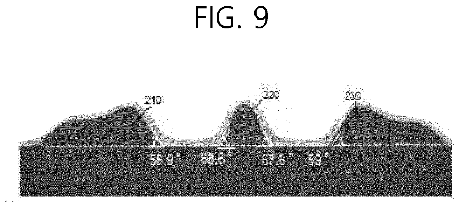

FIG. 9 is a photograph of the cross-section of a bank structure manufactured by an experimental example.

FIG. 9 shows the bank structure formed by performing the light exposure process once using the mask shown in FIG. 8.

As shown in FIG. 9, it may be confirmed that an isolated protrusion pattern 220 located at the center of the bank structure has a triangular cross-section having a round top apex, and the isolated protrusion pattern 220 and third and fourth areas 210 and 230 have different internal angles, *i.e.*, the internal angles of the isolated protrusion pattern 220 are 68.6° and 67.8° and the internal angles α₂ and α₁ of the third area 230 and the fourth area 210 are 58.9° and 59°. Further, it may be confirmed that the thickness of the bank structure in the third area 230 and the fourth area 210 spaced apart from the isolated protrusion pattern 220 by respective slits is greater the thickness of the bank structure at the edges of the bank structure adjacent to respective light emitting parts.

In the bank structure, the light emitting display device including the bank structure, and a method of manufacturing the same according to the present disclosure, the bank structure may be formed to have three or more steps using one mask, thereby being capable of effectively preventing lateral leakage current between adjacent light emitting parts.

The isolated protrusion pattern having a high angle of inclination of the inclined side surfaces thereof is formed between the slits at the center of the bank structure by the width of the light shielding part of the mask and the thickness of the photosensitive material, and the intermediate layer is stacked thinly on the isolated protrusion pattern due to step coverage, thereby doubling the color leakage prevention effect through prevention of lateral leakage current.

Further, compared to a well-known method in which a plurality of masks is used because slits or trench structures are separately formed after formation of a bank, process optimization, reduction in use of hazardous substances, and production energy saving may be achieved due to reduction in the number of masks used. Therefore, the Environmental, Social, and Governance (ESG) effect may be acquired in terms of eco-friendly, low power consumption and process optimization advantages.

As is apparent from the above description, the present disclosure relates to a bank structure, a light emitting display device including the bank structure, and a method of manufacturing the same.

In the bank structure, the light emitting display device including the bank structure, and the method of manufacturing the same according to the present disclosure, the bank structure may be formed to have three or more steps using one mask, thereby being capable of effectively preventing lateral leakage current between adjacent light emitting parts.

A bank structure to an embodiment of the present disclosure may comprise a first area to neighbor a first light emitting part emitting a first color and to have a first height, a second area to neighbor a second light emitting part emitting a second color and to have the first height, a plurality of slits parallel to each other between the first area and the second area, an isolated protrusion pattern between the plurality of slits and to have a second height greater than the first height, a third area connected to the first area and to have the second height, the third area adjacent to one of the plurality of slits and a fourth area connected to the second area and to have the second height, the fourth area adjacent to another slit.

In a bank structure according to an embodiment of the present disclosure, the first light emitting part and the second light emitting part may be parallel along a first direction, and the plurality of slits is provided along the first direction.

In a bank structure according to an embodiment of the present disclosure, the first area, the third area, the slit and the isolated protrusion pattern may be sequentially provided from the first light emitting part to the isolated protrusion pattern.

In a bank structure according to an embodiment of the present disclosure, the first area, the second area, the third area, the fourth area and the isolated protrusion pattern may comprise the same photosensitive organic material.

In a bank structure according to an embodiment of the present disclosure, the second area, the isolated protrusion pattern and the fourth area may be provided along a long side of the first light emitting part. In a bank structure according to an embodiment of the present disclosure, the third area, the isolated protrusion pattern and the fourth area may have ends located farther outwards than ends of the long side of the first light emitting part.

In a bank structure according to an embodiment of the present disclosure, each of the isolated protrusion pattern and the third and fourth areas adjacent to the isolated protrusion pattern may have an internal angle 55° to 75° with respect to a forming surface.

In a bank structure according to an embodiment of the present disclosure, an internal angle of an inclined side surface of the isolated protrusion pattern with respect to a forming surface may be 65° to 75°.

In a bank structure according to an embodiment of the present disclosure, the isolated protrusion pattern may have a trapezoidal cross-section or a triangular cross-section having a round top apex.

In a bank structure according to an embodiment of the present disclosure, a width of a lower surface of the isolated protrusion pattern may be equal to or less than a width of the slits.

In a bank structure according to an embodiment of the present disclosure, a third light emitting part neighboring the second light emitting part and emitting light of a third color may be adjacent to the second area.

In a bank structure according to an embodiment of the present disclosure, the second light emitting part and the third light emitting part may be disposed along a length direction of the slits.

In a bank structure according to an embodiment of the present disclosure, a first internal angle of the third and fourth areas with respect to the forming surface is smaller than a second internal angle of the isolated protrusion pattern with respect to a forming surface. That is, the second internal angle β₁ and β₂, is greater than the first internal angle α₁ and α,.

In a bank structure according to an embodiment of the present disclosure, the first area may overlap a first anode, and the second area overlaps a second anode. Also, an edge of the first anode may be spaced apart from the third area, and an edge of the second anode may be spaced apart from the fourth area.

A bank structure according to an embodiment of the present disclosure, may further comprise a spacer at the first area, the spacer having a third height greater than the second height.

In a bank structure according to an embodiment of the present disclosure, the first light emitting part may emit blue light and the second light emitting part may emit green light or red light.

A light emitting display device to an embodiment of the present disclosure may comprise the bank structure between the first light emitting part and the second light emitting part on a planarization film and a light emitting device at each of the first light emitting part and the second light emitting part.

In a light emitting display device according to an embodiment of the present disclosure, the light emitting device may comprise an anode, at least one emissive layer, at least one common layer, and a cathode. In a light emitting display device according to an embodiment of the present disclosure, the at least one common layer may be in contact with the planarization film in the slits.

In a light emitting display device according to an embodiment of the present disclosure, a thickness of the light emitting device on a surface of the isolated protrusion pattern may be smaller than a thickness of the light emitting device on the slits.

A light emitting display device according to an embodiment of the present disclosure may a first anode and a second anode spaced apart from each other, a bank structure to expose a first light emitting part of the first anode and a second light emitting part of the second anode, a first emissive layer on the first anode to emit light of a first color, and a second emissive layer on the second anode to emit light of a second color, at least one common layer to overlap the first emissive layer, the second emissive layer and the bank structure, and a cathode on the at least one common layer.

The bank structure may comprise a first area to neighbor a first light emitting part emitting a first color and a second area to neighbor a second light emitting part emitting a second color, the first area and the second area having a first height, a plurality of slits parallel to each other between the first area and the second area, an isolated protrusion pattern between the plurality of slits and to have a second height greater than the first height, a third area connected to the first area and to have the second height, the third area adjacent to one of the plurality of slits and a fourth area connected to the second area and to have the second height, the fourth area adjacent to another slit.

In a light emitting display device to an embodiment of the present disclosure, the first area, the second, the third area, the fourth area and the isolated protrusion pattern may comprise the same photosensitive organic material.

In a light emitting display device to an embodiment of the present disclosure, each of the third area, the isolated protrusion pattern and the fourth area may have an internal angle 55° to 75° with respect to a forming surface.

In a light emitting display device to an embodiment of the present disclosure, an internal angle of an inclined side surface of the isolated protrusion pattern may be 65° to 75° with respect to a forming surface.

In a light emitting display device to an embodiment of the present disclosure, the isolated protrusion pattern may have a trapezoidal cross-section or a triangular cross-section having a round top apex.

A method of manufacturing a light emitting display device according to an embodiment of the present disclosure, may comprise preparing a substrate having a first light emitting part and a second light emitting part spaced apart from each other, coating a photosensitive material to an entire surface of the substrate, placing a mask comprising a first semi-transmitting part and a second semi-transmitting part corresponding to edges of the first and second light emitting parts, at least three light shielding parts between the first and second semi-transmitting parts to be spaced apart from each other, and light transmitting parts located between the at least three light shielding parts, on the photosensitive material and forming a bank structure comprising an isolated protrusion pattern corresponding to one of the at least three light shielding parts between the light transmitting parts, slits corresponding to the light transmitting parts, and areas having dual heights corresponding to the first and second semi-transmitting parts by exposing the photosensitive material to light through the mask.

It will be apparent to those skilled in the art that various modifications and variations can be made in the present disclosure without departing from the scope of the disclosure. Thus, it is intended that the present disclosure cover the modifications and variations of this disclosure provided they come within the scope of the appended claims and their equivalents.

The various embodiments described above can be combined to provide further embodiments. All of the U.S. patents, U.S. patent application publications, U.S. patent applications, foreign patents, foreign patent applications and non-patent publications referred to in this specification and/or listed in the Application Data Sheet are incorporated herein by reference, in their entirety. Aspects of the embodiments can be modified, if necessary to employ concepts of the various patents, applications and publications to provide yet further embodiments.

These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

Also disclosed herein are a number of examples according to the following numbered clauses.

Clause 1. A display device comprising:
a substrate;
a first pixel positioned on the substrate;
a second pixel positioned on the substrate, the second pixel being spaced from the first pixel;
a protective layer on the substrate and extending between the first and second pixel;
a bank layer overlaying protective layer, the bank layer having a first bank portion adjacent to the first pixel and a second bank portion spaced from the first bank portion and adjacent to the second pixel;
a stack of light emitting layers being positioned in each of the first and second pixels and overlying the first and second bank portions; and
a space between the first and second bank portions, the space exposing the protective layer at a location between the first and second bank portions of the bank layer;
wherein the first and second bank portions have respective sidewalls adjacent to the space; and
the stack of light emitting layers has a first thickness in the first and second pixels and a second thickness, lower thickness on the respective sidewalls of the first and second bank portions adjacent to the space.

Clause 2. The display device of clause 1, further comprising:
a third bank portion positioned on the protective layer in the space between the first and second bank portions and occupying a region of the space;
a first space between the first bank portion and the third bank portion; and
a second space between the second bank portion and the third bank portion,
wherein each of the first and second spaces is portion of the space.

Clause 3. The display device of clause 2, wherein the third bank portion has a first sidewall positioned adjacent to the first space and a second sidewall adjacent to second space, and
the stack of light emitting layers has a third thickness on the first and second sidewalls of the third bank portion that is less than the second thickness.

Clause 4. The display device of any preceding clause,
wherein the first bank portion has a first region of a first height adjacent to the first pixel and a second region of a second height adjacent to the space, and
the second bank portion has a first region of the first height adjacent to the second pixel and a second region of the second height adjacent to the space; and
the second height in each of the first and second bank portions is greater than the first height in each of the first and second bank portions.

Clause 5. The display device of clause 4, wherein the stack of light emitting layers has the first thickness on a top surface of the respective first regions of the first and second bank portions.

Clause 6. The display device of clause 4 or clause 5, further comprising:
a third bank portion positioned on the protective layer in the space between the first and second bank portions and occupying a region of the space, the third bank portion having a third height greater than the first height.

Clause 7. The display device of clause 6, wherein the third height is equal to the second height.

Clause 8. The display device of clause 6 or clause 7, wherein the third height is greater than the second height.

Clause 9. The display device of any preceding clause, wherein the first bank portion has a first height, the second bank portion has a second height and the third bank portion has a third height.

Clause 10. The display device of clause 9, wherein each of the first height, the second height and the third height are equal to each other.

Clause 11. The display device of clause 9 or clause 10, wherein the first height, the second height are equal to each other and the third height is greater than the both the first and second heights.

Clause 12. The display device according to any of clauses 9 to 11, further comprising:
a fourth bank portion spaced from the first, second bank and third bank portions, the fourth bank portion having a fourth height that is greater than each of the first, second and third heights.

Clause 13. The display device of any preceding clause, wherein the angle of the respective sidewalls of the first and second bank portions adjacent to the space is between 55° to 75° relative to the protective layer.

Clause 14. The display device of clause 3, wherein the angle of the sidewalls of the third bank portion adjacent to the first and second spaces is greater than the angle of the respective sidewalls of the first and second bank portions adjacent to the first and second spaces relative to the protective layer.

Clause 15. The display device of clause 14, wherein angle of the sidewalls of the third bank portion adjacent to the first and second spaces is between 60° and 80°.

Clause 16. A bank structure positioned between a first pixel and a second pixel, the bank structure comprising:
a first bank portion adjacent to the first pixel, the first bank portion having a first region portion and a second region, the first region having a first height and the second region having a second height that is greater than the first height.
a second bank portion adjacent to the second pixel, the second bank portion having a first region and a second region, the first region having the first height and the second region having the second height; and
a space between the first and second portion.

Clause 17. The bank structure of clause 16, further comprising a third bank portion positioned in the space between the first and second portion, a first space between the third bank portion and the first portion, and a second space between the third bank portion and the second portion, the third bank portion having a third height at a central portion thereof.

Clause 18. The bank structure of clause 17, wherein the third height is greater than the second height.

Clause 19. A display device comprising
a substrate;
a first pixel positioned on the substrate;
a second pixel positioned on the substrate, the second pixel being spaced from the first pixel;
a protective layer on the substrate and extending between the first and second pixel;
a bank layer overlaying protective layer, the bank having a first bank portion positioned adjacent to the first pixel, a second bank portion spaced from the first bank portion and positioned adjacent to the second pixel and a third bank portion positioned between the first and second bank portions;
a stack of light emitting layers being positioned in each of the first and second pixels and overlying the first, second and third bank portions;
a first space between the first and third bank portions, the first space exposing the protective layer at a location between the first and third bank portions; and
a second space between the second and third bank portions, the second space exposing the protective layer at a location between the second and third bank portions, wherein:
   the first bank portion has a sidewall adjacent to the first space, the second bank portion has a sidewall adjacent to the second space, and
   the third bank portion has a sidewall adjacent to the first space and a sidewall adjacent to the second space; and
   the stack of light emitting layers has a first thickness in the first and second pixels and a second thickness, lower thickness on the respective sidewalls of the each of the sidewalls of the first, second and third bank portions.

Clause 20. The display device of clause 19, further comprising:
a fourth bank portion positioned on the protective layer and spaced from each of the first, second and third bank portions, the fourth bank portion having sidewalls with the stack of light emitting layers thereon having a third thickness.

Clause 21. The display device of clause 19 or clause 20, wherein a thickness of the stack of light emitting layers on the sidewalls of the third portion is less than the thickness of the stack of light emitting layers on the sidewalls of the first and second portions.

Clause 22. A method of manufacturing a light emitting display device, comprising:
preparing a substrate having two pixels formed therein, the first pixel having a first light emitting part and the second pixel having a second light emitting part spaced apart from the first light emitting part;
coating a photosensitive material over an entire surface of the substrate;
placing a mask having a first semi-transmitting part and a second semi-transmitting part positioned over the photosensitive material adjacent to edges of the first and second light emitting parts and a light transmitting part positioned between the first and second semi-transmitting parts;
exposing the photosensitive material to light via the mask; and
forming a bank structure based on the light exposure of the etchable material to provide first and second portions of the bank each having first region of a first height and a second region of a height and a space between the first and second portions corresponding to the light transmitting part positioned between the first and second semi-transmitting parts. The method may be a method of manufacturing a display device according to clause 1 or clause 19.

Clause 23. The method of clause 22, further comprising:
a light shielding part positioned between the first and second semi-transmitting parts, the light shielding part among the light transmitting part; and
forming a third bank portion between the first and second bank portions as the same time the first and second bank portions are formed, the third bank portion corresponding to the light shielding part.

Clause 24. The method of clause 22 or clause 23, further comprising:
forming a bank layer comprised of a first etchable material over the substrate prior to the step of coating the photosensitive material over an entire surface of the substrate, the photosensitive materials being comprised of a second etchable material, different material from the first etchable material.

Clause 25. The method of clause 23 or clause 24, wherein the bank structure is comprised of the photosensitive material.

## Claims

1. A display device comprising:
a substrate;
a first pixel positioned on the substrate;
a second pixel positioned on the substrate, the second pixel being spaced from the first pixel;
a protective layer on the substrate and extending between the first and second pixel;
a bank layer overlaying protective layer, the bank layer having a first bank portion adjacent to the first pixel and a second bank portion spaced from the first bank portion and adjacent to the second pixel;
a stack of light emitting layers being positioned in each of the first and second pixels and overlying the first and second bank portions; and
a space between the first and second bank portions, the space exposing the protective layer at a location between the first and second bank portions of the bank layer;
wherein the first and second bank portions have respective sidewalls adjacent to the space; and
the stack of light emitting layers has a first thickness in the first and second pixels and a second, lower thickness on the respective sidewalls of the first and second bank portions adjacent to the space.

2. The display device of claim 1, further comprising:
a third bank portion positioned on the protective layer in the space between the first and second bank portions and occupying a region of the space;
a first space between the first bank portion and the third bank portion; and
a second space between the second bank portion and the third bank portion,
wherein each of the first and second spaces is portion of the space.

3. The display device of claim 2, wherein the third bank portion has a first sidewall positioned adjacent to the first space and a second sidewall adjacent to second space, and
the stack of light emitting layers has a third thickness on the first and second sidewalls of the third bank portion that is less than the second thickness.

4. The display device of any preceding claim,
wherein the first bank portion has a first region of a first height adjacent to the first pixel and a second region of a second height adjacent to the space, and
the second bank portion has a first region of the first height adjacent to the second pixel and a second region of the second height adjacent to the space; and
the second height in each of the first and second bank portions is greater than the first height in each of the first and second bank portions.

5. The display device of claim 4, wherein the stack of light emitting layers has the first thickness on a top surface of the respective first regions of the first and second bank portions.

6. The display device of claim 4 or claim 5, further comprising:
a third bank portion positioned on the protective layer in the space between the first and second bank portions and occupying a region of the space, the third bank portion having a third height greater than the first height.

7. The display device of claim 6, wherein the third height is equal to the second height, or wherein the third height is greater than the second height.

8. The display device of claim 2, wherein the first bank portion has a first height, the second bank portion has a second height and the third bank portion has a third height.

9. The display device of claim 8, wherein each of the first height, the second height and the third height are equal to each other; or wherein the first height and the second height are equal to each other, and the third height is greater than the both the first and second heights.

10. The display device of claim 9, further comprising:
a fourth bank portion spaced from the first, second bank and third bank portions, the fourth bank portion having a fourth height that is greater than each of the first, second and third heights.

11. The display device of any preceding claim, wherein the angle of the respective sidewalls of the first and second bank portions adjacent to the space is between 55° to 75° relative to the protective layer.

12. The display device of claim 3, wherein the angle of the sidewalls of the third bank portion adjacent to the first and second spaces is greater than the angle of the respective sidewalls of the first and second bank portions adjacent to the first and second spaces relative to the protective layer; and optionally wherein angle of the sidewalls of the third bank portion adjacent to the first and second spaces is between 60° and 80°.

13. A method of manufacturing a light emitting display device, comprising:
preparing a substrate having two pixels formed therein, the first pixel having a first light emitting part and the second pixel having a second light emitting part spaced apart from the first light emitting part;
coating a photosensitive material over an entire surface of the substrate;
placing a mask having a first semi-transmitting part and a second semi-transmitting part positioned over the photosensitive material adjacent to edges of the first and second light emitting parts and a light transmitting part positioned between the first and second semi-transmitting parts;
exposing the photosensitive material to light via the mask; and
forming a bank structure based on the light exposure of the etchable material to provide first and second portions of the bank each having first region of a first height and a second region of a height and a space between the first and second portions corresponding to the light transmitting part positioned between the first and second semi-transmitting parts.

14. The method of claim 13, further comprising:
a light shielding part positioned between the first and second semi-transmitting parts, the light shielding part among the light transmitting part; and
forming a third bank portion between the first and second bank portions as the same time the first and second bank portions are formed, the third bank portion corresponding to the light shielding part.

15. The method of claim 13 or claim 14, further comprising:
forming a bank layer comprised of a first etchable material over the substrate prior to the step of coating the photosensitive material over an entire surface of the substrate, the photosensitive materials being comprised of a second etchable material, different material from the first etchable material.
